# EUROPEAN PATENT APPLICATION

(11) **EP 2 784 806 A1**
(43) Date of publication of application: **01.10.2014**
(21) Application number: 12851832.1
(22) Date of filing: 14.09.2012
(51) Int. Cl.: H01L 21/336, H01L 29/12, H01L 29/78

(54) **METHOD FOR MANUFACTURING SEMICONDUCTOR DEVICE**

(30) Priority: 24.11.2011 JP 2011255675
(71) Applicant: Sumitomo Electric Industries, Ltd., Osaka-shi, Osaka 541-0041 (JP)
(72) Inventor: SHIOMI, Hiromu, Osaka-shi Osaka 554-0024 (JP)
(74) Representative: Grünecker, Kinkeldey, Stockmair & Schwanhäusser
(86) International application number: PCT/JP2012/073596
(87) International publication number: WO 2013/077068

(57) **Abstract**

A method for manufacturing a semiconductor device has the following steps. A substrate (10) having a silicon carbide layer (122) of a first conductivity type is prepared. On the silicon carbide layer (122), a mask layer (1) is formed. By ion implantation from above the mask layer (1), a well region (123) of a second conductivity type is formed on the silicon carbide layer (122). At the step of forming the mask layer (1), the mask layer (1) having an opening with a taper angle, which is an angle formed between a bottom surface and an inclined surface of mask layer (1), being larger than 60° and not larger than 80° is formed. Thus, a method of manufacturing a semiconductor device, capable of producing a semiconductor device having high degree of integration and high breakdown voltage, can be provided.

## Description

### TECHNICAL FIELD

The present invention relates to a method for manufacturing a semiconductor device and, more specifically, to a method for manufacturing a semiconductor device having a silicon carbide layer.

### BACKGROUND ART

Recently, methods of manufacturing MOSFET (Metal Oxide Semiconductor Field Effect Transistor) using silicon carbide have been studied. A well region of an MOSFET is formed, for example, by introducing impurity ions to a silicon carbide layer According to a method disclosed in Japanese Patent Laying-Open No. 6-151860 (Patent Literature 1), ion implantation to a silicon carbide substrate is executed using a gate electrode having an inclined surface as a mask, whereby a p region (well region) is formed. According to a method disclosed in Japanese Patent Laying-Open No. 2004-39744 (Patent Literature 2), a mask having an inclined surface is formed on an epitaxial film, and impurity ions are implanted to the epitaxial film from above the mask, whereby a base region (well region) is formed.

### CITATION LIST

### PATENT LITERATURE

PTL 1: Japanese Patent Laying-Open No. 6-151860
PTL 2: Japanese Patent Laying-Open No. 2004-39744

### SUMMARY OF INVENTION

### TECHNICAL PROBLEM

If the mask has a taper angle of 90° and impurity ions are implanted with high energy to the silicon carbide layer, the impurity ions are introduced deeply in the thickness direction of the silicon carbide layer and, at the same time, spread widely in a direction perpendicular to the thickness direction of the silicon carbide layer (hereinafter also referred to as a lateral direction). As a result, a portion protruding to the lateral direction is formed near the deepest portion of the ion-implanted well region. The protruded portion is prone to electric field concentration and, therefore, an MOSFET having such a structure may possibly come to have lower breakdown voltage.

On the other hand, according to the method disclosed in Patent Literature 1, as the mask has a moderate taper angle of 60°, the p region (well region) formed by ion implantation undesirably extends wide in the lateral direction. This makes it difficult to reduce the width in the lateral direction of the p region and, hence, makes it difficult to increase degree of integration of the semiconductor device. Further, according to the method disclosed in Patent Literature 2, impurity ions are implanted obliquely from above a mask having a taper angle of about 10° to about 60°. Accordingly, the base region (well region) undesirably extends in the lateral direction near the deepest portion, resulting in formation of a protruded portion. The protruded portion is prone to electric field concentration and, therefore, the semiconductor device may possibly come to have lower breakdown voltage.

The present invention was made to solve such a problem, and its object is to provide a method of manufacturing a semiconductor device having a high degree of integration and high breakdown voltage

### SOLUTION TO PROBLEM

The present invention provides a method for manufacturing a semiconductor device having the following steps. A substrate having a silicon carbide layer of a first conductivity type is prepared. On the silicon carbide layer, a mask layer is formed. By ion implantation from above the mask layer, a well region of a second conductivity type is formed on the silicon carbide layer. At the step of forming the mask layer, the mask layer having an opening with a taper angle, which is an angle formed between a bottom surface and an inclined surface of the mask layer, being larger than 60° and not larger than 80° is formed.

According to the method of manufacturing a semiconductor device of the present invention, a mask layer having an opening with the taper angle larger than 60° and not larger than 80° is formed, and ions are implanted to the silicon carbide layer from above the mask layer. Since the taper angle is made larger than 60°, the well region does not excessively extend in the direction perpendicular to the thickness direction of the silicon carbide layer and, therefore, it becomes possible to manufacture a semiconductor device with high degree of integration. Further, since the taper angle is not larger than 80°, protrusion in the lateral direction near the deepest portion of the well region can be prevented. As a result, electric field concentration near the deepest portion of the well region can be prevented and, hence, a semiconductor device having high breakdown voltage can be obtained.

In the method for manufacturing a semiconductor device described above, preferably, the step of forming a mask layer includes the step of forming an implantation inhibiting layer on the silicon carbide layer, and the step of forming an opening in the implantation inhibiting layer. Here, "forming an implantation inhibition layer on the silicon carbide layer" encompasses forming another layer on the silicon carbide layer and forming the implantation inhibition layer on the said another layer.

In the method for manufacturing a semiconductor device described above, preferably, the step of forming the opening is conducted by etching the implantation inhibiting layer. Thus, the opening can be formed efficiently.

Preferably, the method for manufacturing a semiconductor device described above further includes the step of, before forming the implantation inhibiting layer, forming a through mask on the silicon carbide layer.

Thus, the implantation inhibition layer is formed on the through mask and, therefore, when the implantation inhibition layer is etched, etching of the silicon carbide layer below the through mask can be prevented.

In the method for manufacturing a semiconductor device described above, preferably, at the step of forming the opening, the implantation inhibiting layer is etched under the condition that selectivity between the through mask layer and the implantation inhibiting layer is not less than 2. Thus, the implantation inhibition layer is efficiently etched while damage to the silicon carbide layer is reduced.

In the method for manufacturing a semiconductor device described above, preferably, ratio of thickness of the implantation inhibiting layer divided by thickness of the through mask layer is not less than 10 and not more than 50. Thus, the through mask layer having the least necessary thickness can be formed.

In the method for manufacturing a semiconductor device described above, preferably, the step of forming the opening includes the step of forming the opening to have the taper angle of 90°, and the step of adjusting the taper angle such that the taper angle of the opening comes to be larger than 60° and not larger than 80°. Thus, the taper angle can be adjusted with high accuracy.

### ADVANTAGEOUS EFFECTS OF INVENTION

According to the manufacturing method of the present invention, a semiconductor device having high degree of integration and high breakdown voltage can be obtained.

### BRIEF DESCRIPTION OF DRAWINGS

Fig. 1 is a schematic cross-sectional view showing a semiconductor device in accordance with an embodiment of the present invention.
Fig. 2 is a flowchart schematically showing the method for manufacturing a semiconductor device in accordance with an embodiment of the present invention.
Fig. 3 is a schematic cross-sectional view showing a first step of the method for manufacturing a semiconductor device in accordance with an embodiment of the present invention.
Fig. 4 is a schematic cross-sectional view showing a second step of the method for manufacturing a semiconductor device in accordance with an embodiment of the present invention.
Fig. 5 is a schematic cross-sectional view showing a third step of the method for manufacturing a semiconductor device in accordance with an embodiment of the present invention.
Fig. 6 is a schematic cross-sectional view showing a fourth step of the method for manufacturing a semiconductor device in accordance with an embodiment of the present invention.
Fig. 7 is a schematic cross-sectional view showing a fifth step of the method for manufacturing a semiconductor device in accordance with an embodiment of the present invention.
Fig. 8 is a schematic cross-sectional view showing a sixth step of the method for manufacturing a semiconductor device in accordance with an embodiment of the present invention.
Fig. 9 is a schematic cross-sectional view showing a seventh step of the method for manufacturing a semiconductor device in accordance with an embodiment of the present invention.
Fig. 10 is a schematic cross-sectional view showing an eighth step of the method for manufacturing a semiconductor device in accordance with an embodiment of the present invention.
Fig. 11 is a schematic cross-sectional view showing a ninth step of the method for manufacturing a semiconductor device in accordance with an embodiment of the present invention.
Fig. 12 is a schematic cross-sectional view showing a tenth step of the method for manufacturing a semiconductor device in accordance with an embodiment of the present invention.
Fig. 13 is a schematic cross-sectional view showing an eleventh step of the method for manufacturing a semiconductor device in accordance with an embodiment of the present invention.
Fig. 14 is a schematic cross-sectional view showing a twelfth step of the method for manufacturing a semiconductor device in accordance with an embodiment of the present invention.
Fig. 15 shows a relation between impurity concentration and the depth direction of well region.
Fig. 16 is a schematic diagram showing a cross-sectional shape of the well region when the mask layer has a taper angle of 90°.
Fig. 17 is a schematic diagram showing a cross-sectional shape of the well region in accordance with an embodiment of the present invention.

### DESCRIPTION OF EMBODIMENTS

In the following, embodiments of the present invention will be described with reference to the figures. In the figures, the same or corresponding portions are denoted by the same reference characters and description thereof will not be repeated.

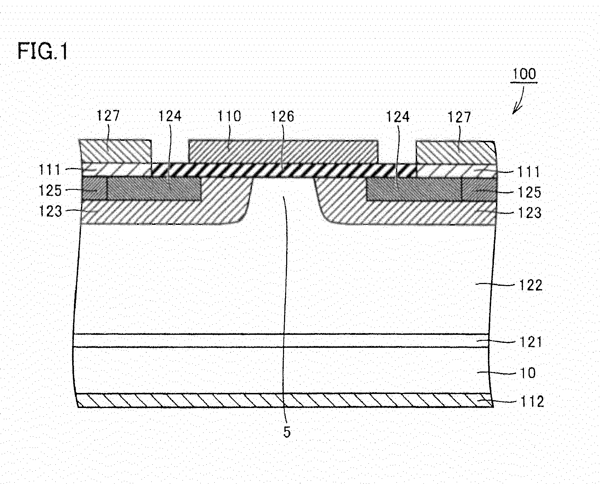

Referring to Fig. 1, a semiconductor device 100 in accordance with the present embodiment is a vertical DiMOSFET (Double Implanted Metal Oxide Semiconductor Field Effect Transistor), having a substrate 10, a buffer layer 121, a breakdown voltage holding layer 122, a well region 123, an n' region 124, a p⁺ region 125, an oxide film 126, a source electrode 111, an upper source electrode 127, a gate electrode 110 and a drain electrode 112.

Substrate 10 is formed, for example, of silicon carbide having n type conductivity. Buffer layer 121 is formed, for example, of silicon carbide having n type conductivity, and has a thickness of, for example, 0.5 µm. Further, concentration of n type conductivity in buffer layer 121 is, for example, 5×10¹⁷ cm⁻³. The impurity concentration of buffer layer 121 is smaller than that of substrate 10.

Breakdown voltage holding layer 122 is formed on buffer layer 121 and is formed of silicon carbide having n type conductivity. By way of example, breakdown voltage holding layer 122 has a thickness of 10 µm and n type impurity concentration of 5 × 10¹⁵ cm⁻³. The thickness of breakdown voltage holding layer 122 is thicker than that of buffer layer 121, and the impurity concentration of breakdown voltage holding layer 122 is smaller than that of buffer layer 121.

On a region including the surface of breakdown voltage holding layer 122, a plurality of well regions 123 having p type conductivity are formed spaced apart from each other. The width of well region 123 becomes smaller toward the bottom portion (to the substrate side) of well region 123. In other words, width of a JEFT region 5 between two well regions 123 becomes wider in the direction from the surface of silicon carbide layer 122 toward the substrate 10.

In well region 123, an n⁺ region 124 is formed at a surface layer of well region 123. A p⁺ region 125 is formed at a position next to n⁺ region 124. Extending from above n⁺ region 124 on one well region 123 over breakdown voltage holding layer 122 exposed between two p-regions 123, the other well region 123 and above n⁺ region 124 in the said the other well region 123, oxide film 126 is formed. On oxide film 126, gate electrode 110 is formed. Further, on n⁺ region 124 and p⁻ region 125, source electrode 111 is formed. On source electrode 111, an upper source electrode 127 is formed.

Next, the method for manufacturing semiconductor device 100 will be described.

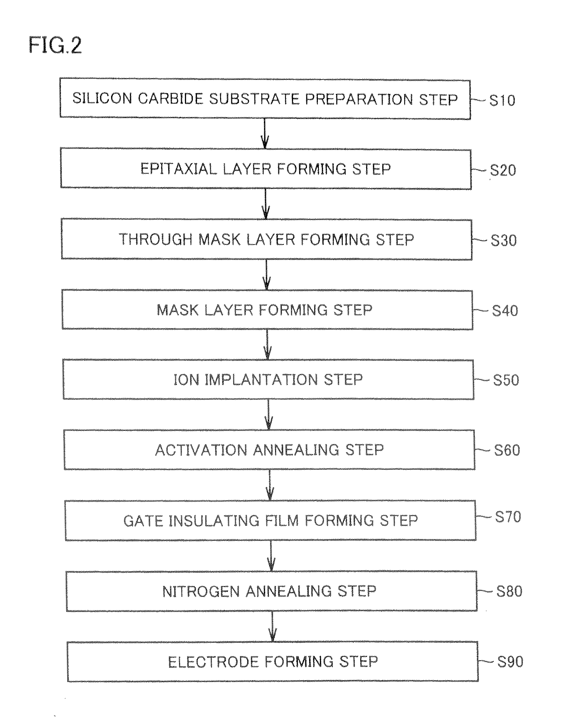

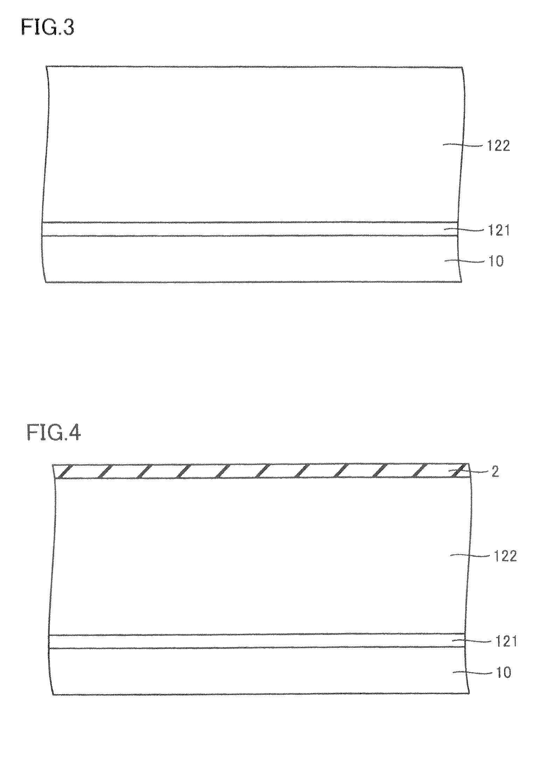

Referring to Fig. 3, first, at the substrate preparation step (step S10: Fig. 2), substrate 10 of silicon carbide is prepared. The conductivity type of substrate 10 is, for example, n type (first conductivity type).

Next, at the epitaxial layer forming step (step S20: Fig. 2), buffer layer 121 and breakdown voltage holding layer 122 are formed in the following manner.

First, on a surface of substrate 10, buffer layer 121 is formed. Buffer layer 121 is formed of silicon carbide having n-type conductivity (first conductivity type) and, by way of example, it is an epitaxial layer of 0.5 µm in thickness. Further, concentration of n type conductive impurity in buffer layer 121 is, for example, 5 × 10¹⁷ cm⁻³

Next, breakdown voltage holding layer 122 is formed on buffer layer 121. Specifically, a layer formed of silicon carbide having n-type conductivity (first conductivity type) is formed by epitaxial growth. The thickness of breakdown voltage holding layer 122 is, for example, 10 µm. Concentration of n-type conductive impurity in breakdown voltage holding layer 122 is, for example, 5 × 10¹⁵cm⁻³.

Referring to Fig. 4, at the through mask forming step (step S30: Fig. 2), through mask 2 if formed on breakdown voltage holding layer 122. The material of through mask 2 is, for example, polysilicon. Through mask layer 2 is formed, for example, by CVD (Chemical Vapor Deposition) on breakdown voltage holding layer 122.

At an ion implantation step as will be described later, impurity ions are implanted to silicon carbide layer 122 through through mask layer 2. If through mask layer 2 is thick, passage of impurity ions is prevented by through mask 2 at the time of ion implantation. Therefore, from the viewpoint of ion implantation efficiency, the thickness of through mask 2 should preferably be small.

On the other hand, at the step of etching mask layer 1 as will be described later, through mask layer 2 also has a function of a so-called etch stop layer, for preventing silicon carbide layer 122 formed below through mask layer from being etched. If through mask 2 is thin, through mask 2 would be fully etched away, and the function of etch stop layer cannot be attained. Therefore, considering the function as an etch stop layer, the thickness of through mask 2 should preferably be large.

Considering both the impurity implantation efficiency and the function as an etch stop layer, preferable thickness of through mask layer 2 is in the range of about 0.02 µm to about 0.2 µm.

Further, an oxide film (protective film) may be provided between through mask layer 2 and breakdown voltage holding layer 122.

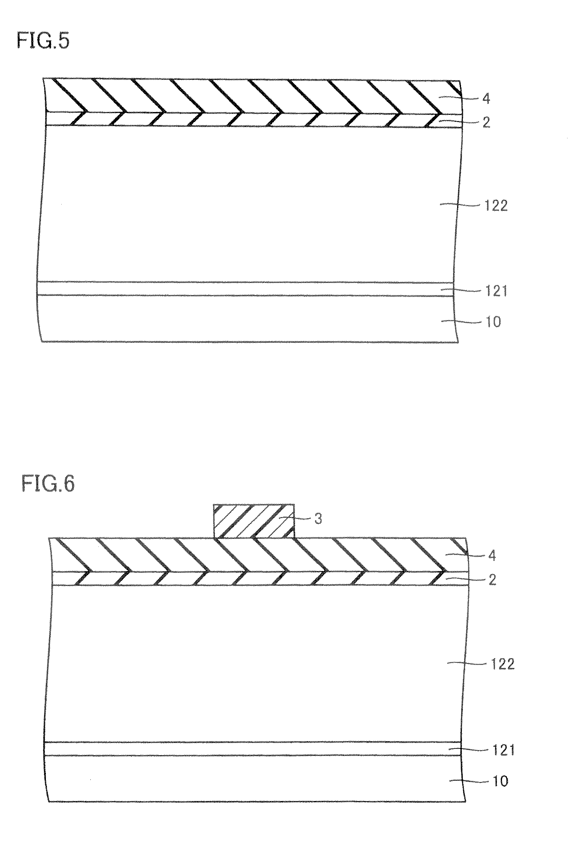

Referring to Fig. 5, the mask layer forming step (step S40: Fig. 2) is executed. The step of forming mask layer 1 includes the step of forming an implantation inhibiting layer 4 on silicon carbide layer 122, and the step of forming an opening in implantation inhibiting layer 4. First, on through mask layer 2 formed on silicon carbide layer 122, implantation inhibiting layer 4 is formed. The material of implantation inhibiting layer 4 is, for example, silicon dioxide (SiO₂). Implantation inhibiting layer 4 is formed, for example, by CVD. Thickness of implantation inhibiting layer 4 is, for example, 2 µm.

Implantation inhibiting layer 4 has a function of preventing ion implantation to silicon carbide layer 122 at the ion implantation step as will be described later. If implantation inhibiting layer 4 is formed on some portions of silicon carbide layer 122 and not on others, ions are hardly implanted to the portions of silicon carbide layer 122 provided with implantation inhibiting layer 4, while ions are implanted at the portions not provided with implantation inhibiting layer 4. Preferable thickness of implantation inhibiting layer 4 is, for example, about 1.5 µm to about 20 µm. Further, film thickness ratio of the thickness of implantation inhibiting layer 4 divided by the thickness of through mask layer 2 should preferably be about 10 to about 50.

Referring to Fig. 6, on implantation inhibiting layer 4, a photo-resist pattern 3 is formed. Photo-resist pattern 3 is formed to have openings at positions where well regions 123 are formed at the ion implantation step as will be described later. Photo-resist pattern 3 may be formed by applying photo-resist on the entire surface of implantation inhibiting layer 4, curing portions other than the portions corresponding to the openings, and by removing the un-cured portions corresponding to the openings.

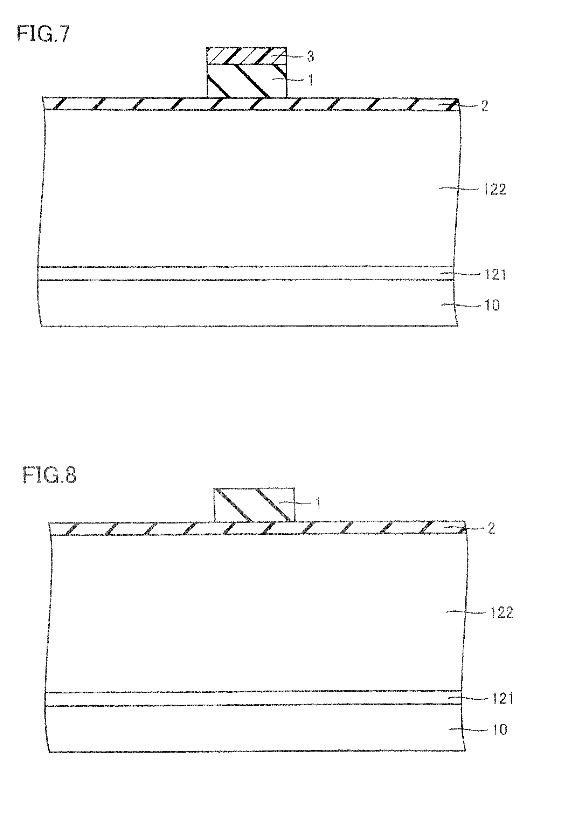

Referring to Fig. 7, etching is done using photo-resist pattern 3 as a mask. Etching is, for example, RIE (Reactive Ion Etching) using a gas containing, for example, CHF₃. Consequently, parts of implantation inhibiting layer 4 positioned at the openings of photo-resist pattern 3 are etched in the thickness direction (vertical direction in the figure), and thus, openings (in the figure, portions at the right and left of mask layer 1) are formed in implantation inhibiting layer 4. In this manner, mask layer 1 having a taper angle of about 90° is formed.

It is noted that part of through mask 2 may be removed by the etching described above. Further, it is preferred that etch selectivity between through mask layer 2 and implantation inhibiting layer 4 is not less than 2. More preferably, the etch selectivity between through mask layer 2 and implantation inhibiting layer 4 is not less than 2 and not more than 10.

Referring to Fig. 8, photo-resist pattern 3 left on mask layer 1 is removed.

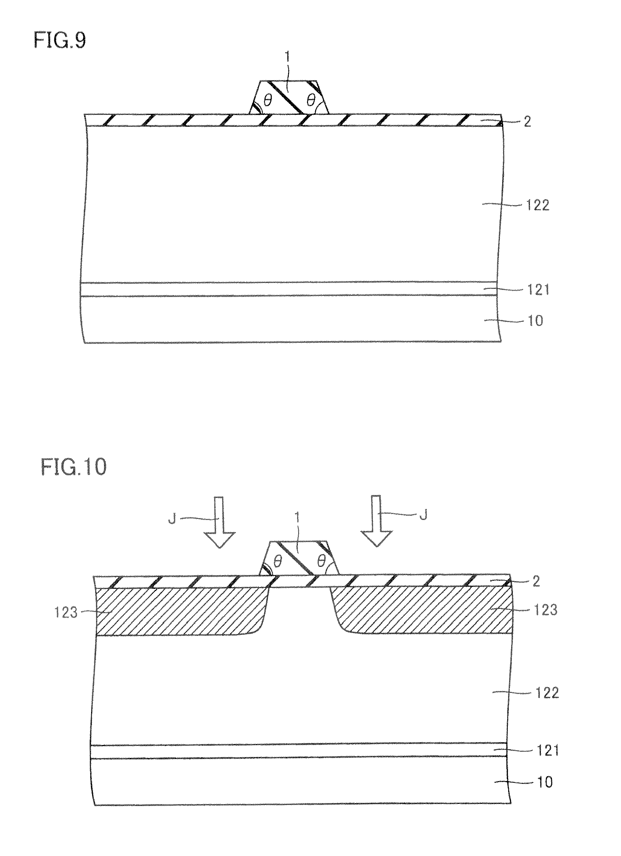

Referring to Fig. 9, shoulder portions of mask layer 1 are etched, to provide a taper angle θ at mask layer 1. By way of example, a mixed gas of CF4 and O₂ is used for the etching, and the pressure is I Pa. Microwave power is, for example, 900W. Thus, the taper angle is adjusted such that mask layer 1 having an opening with the taper angle larger than 60° and not larger than 80° is formed.

Composition ratio of the mixed gas (O₂/(CF₄ + O₂)) used for etching is, preferably, not less than 10% and not more than 50%. For instance, if the composition ratio (O₂/(CF₄ + O₂)) is 15%, 20%, 25%, 30%, 35% and 40%, respectively, the taper angle will be about 84°, 80°, 76°, 73°, 70° and 54°, respectively.

The taper angle θ refers to an angle formed between the bottom surface (the lower side surface in the figure) and the inclined surface of mask layer 1.

Referring to Fig. 10, at the implantation step (step S50: Fig. 2), well region 123 is formed in the following manner.

First, by implanting p type (second conductivity type) impurity ions to silicon carbide layer 122 from above mask layer 1, well region 123 is formed in silicon carbide layer 122. Here, by way of example, ion implantation J is carried out by introducing ions of p type (second conductivity type) impurity to silicon carbide layer 122 through through mask 2 from the opening of mask layer 1. As the p type impurity, aluminum, for example, may be used. It is noted that ion implantation J is done in the thickness direction of silicon carbide layer 122.

The ion implantation J may be realized by implanting impurity ions with different implantation energy in several steps (multi-step implantation). If the implantation energy is high, the impurity ions reach deep into silicon carbide layer 122, and if the implantation energy is low, impurity ions stay at shallow portions of silicon carbide layer 122.

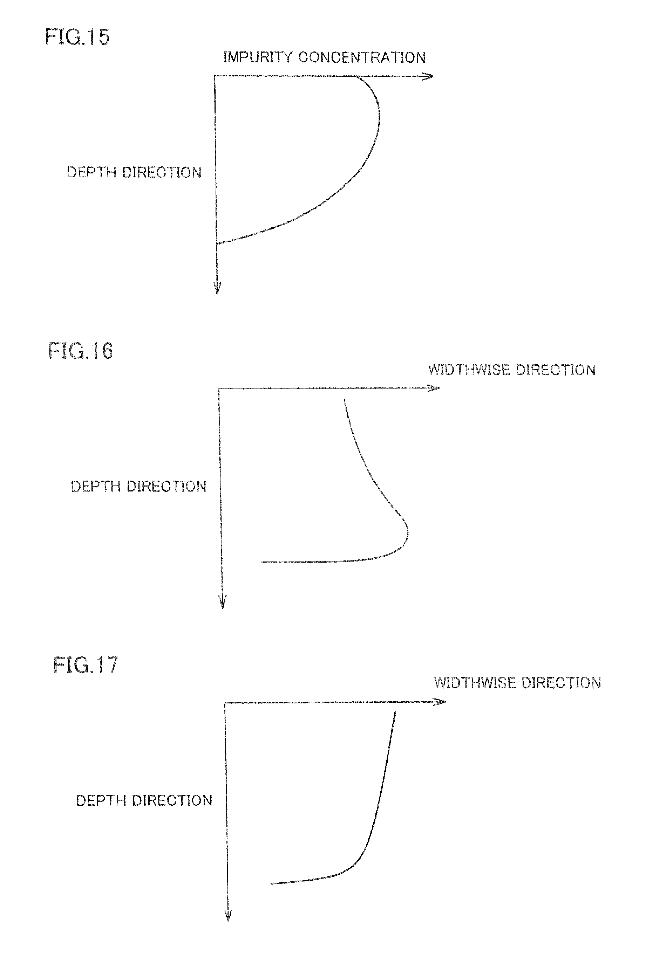

Fig. 15 shows impurity ion concentration in the depth direction of well region 123. By way of example, by the multi-step implantation described above, a well region 123 having the impurity ion concentration varied in the depth direction as shown in Fig. 15 is obtained.

Fig. 16 shows a cross-sectional shape of well region 123 when the taper angle of mask layer 1 is 90°. As can be seen from Fig. 16, well region 123 extends protruding in the lateral direction near the deepest portion of well region 123. The protruded portion extending in the lateral direction is prone to electric field concentration and, hence, possibly becomes a cause of lower breakdown voltage of semiconductor device 100.

On the other hand, Fig. 17 shows a cross-sectional view of well region 123 when the taper angle of mask layer I is larger than 60° and not larger than 80°. As can be seen from Fig. 17, the expansion of well region 123 in the lateral direction (widthwise direction) becomes narrower towards the bottom side (substrate side) of well region 123. Further, when the taper angle is larger than 60° and not larger than 80°, the protruding portion extending in the lateral direction (widthwise direction) near the deepest portion of well region 123 as seen when the taper angle is 90° is not formed. Therefore, it becomes possible to prevent electric field concentration near the deepest portion of well region 123. Further, it is possible to prevent JFET region 5 from being made narrower by the protruding portion formed near the deepest portion of well region 123.

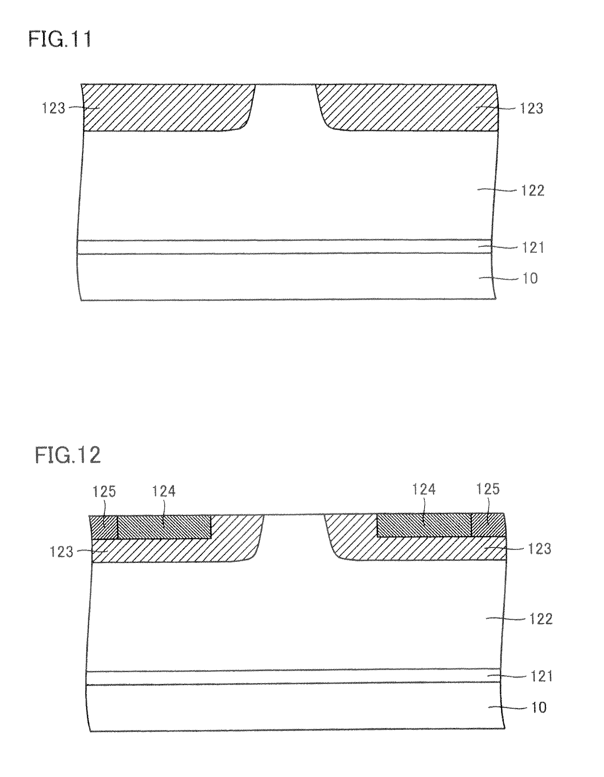

Referring to Fig. 11, mask layer 1 and through mask layer 2 are removed. Mask layer 1 and through mask layer 2 are removed, for example, by etching with hydrofluoric acid.

Referring to Fig. 12, n⁺ region 124 and p⁺ region 125 are formed in the following manner. By selectively implanting n type impurity to a prescribed region, n' region 124 is formed, and by selectively implanting conductive impurity having p type conductivity to a prescribed region, p' region 125 is formed. Selective implantation of the impurity is conducted using, for example, a mask formed of an oxide film.

Following the implantation step as such, an activation annealing step (step S60: Fig. 2) is done. By way of example, annealing is done in an argon atmosphere, at a heating temperature of 1700°C for 30 minutes.

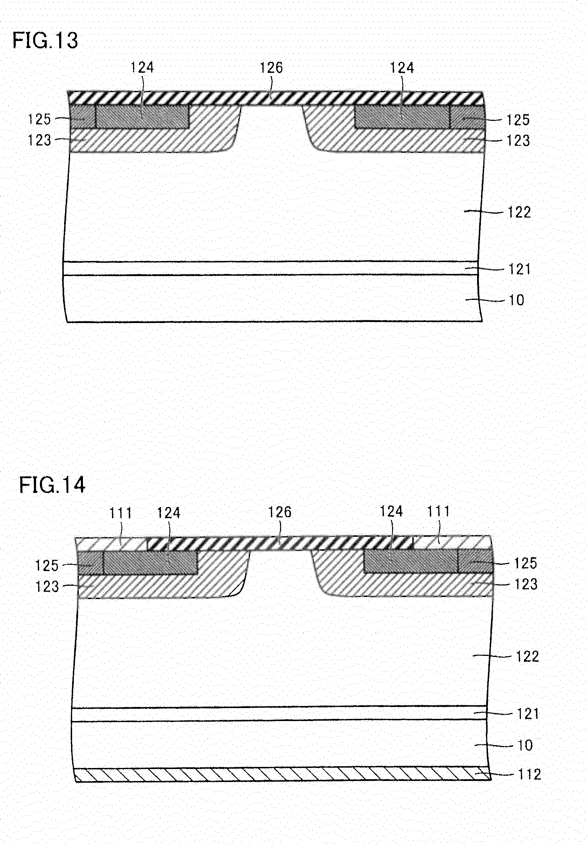

Referring to Fig. 13, the gate insulating film forming step (step S70: Fig. 2) is performed. Specifically, oxide film 126 is formed to cover breakdown voltage holding layer 122, well region 123, n' region 124 and p⁺ region 125. The film may be formed by dry oxidation (thermal oxidation). Conditions for dry oxidation are, for example, heating temperature of 1200°C and heating time of 30 minutes.

Thereafter, the nitrogen annealing step (step S80: Fig. 2) is done. Specifically, annealing is done in a nitrogen monoxide (NO) atmosphere. Conditions for this process are, for example, heating temperature of 1100°C and heating time of 120 minutes As a result, nitrogen atoms are introduced to the vicinity of interface between each of breakdown voltage holding layer 122, well region 123, n⁺ region 124 and p region 125 and oxide film 126.

Following the annealing step using nitrogen monoxide, annealing using argon (Ar) gas as an inert gas may be performed. Conditions for the process are, for example, heating temperature of 1100°C and heating time of 60 minutes.

Referring to Fig. 14, by the electrode forming step (step S90: Fig. 2), source electrode 111 and drain electrode 112 are formed in the following manner.

First, on oxide film 126, using photolithography, a resist film having a pattern is formed. Using the resist film as a mask, portions of oxide film 126 positioned on n⁺ region 124 and p⁺ region 125 are removed by etching Thus, openings are formed in oxide film 126. Next, a conductive film is formed to be in contact with each of n⁺ region 124 and p⁺ region 125 in the openings. Then, the resist film is removed, whereby portions of the conductive film that have been positioned on the resist film are removed (lift off). The conductive film may be a metal film and, by way of example, it is formed of nickel (Ni). As a result of this lift off, source electrode 111 is formed. Further, on a back-side surface of substrate 10, drain electrode 112 is formed.

Here, heat treatment for alloying is preferably carried out. By way of example, heat treatment is done in an atmosphere of argon (Ar) gas as an inert gas, at a heating temperature of 950°C for 2 minutes.

Again referring to Fig. 1, on source electrode 111, upper source electrode 127 is formed. In this manner, semiconductor device 100 is obtained.

It is noted that a structure having conductivity types reversed from the present embodiment, that is, p-type and n-type reversed, may be used. Further, though a DiMOSFET has been described as an example of semiconductor device 100, semiconductor device 100 may be, for example, a trench type MOSFET. Further, the manufacturing method described above may be used for fabricating various semiconductor devices other than MOSFET, such as an IGBT (Insulated Gate Bipolar Transistor) and a diode.

Further, though an example has been described in which silicon dioxide is used as the material for mask layer 1 (implantation inhibiting layer 4) and polysilicon is used as through mask 2 in the present embodiment, polysilicon may be used as the material for mask layer 1 (implantation inhibiting layer 4) and silicon dioxide may be used as the material for through mask layer 2.

Next, functions and effects of the present embodiment will be described.

According to the method for manufacturing semiconductor device 100 of the present embodiment, by ion implantation to silicon carbide layer 122 from above mask layer I having an opening with the taper angle of larger than 60° and not larger than 80°, well region 123 is formed. Accordingly, well region 123 is not excessively extend in the direction perpendicular to the thickness direction of silicon carbide layer 122, and semiconductor device 100 can be formed with high degree of integration. Further, since JFET region 5 is not made narrower by the expansion of well region 123, low on-resistance can be realized. Further, formation of the protruding portion extending in the lateral direction near the deepest portion of well region 123 can be prevented. Therefore, occurrence of electric field concentration near the deepest portion of well region 123 can be prevented and, hence, semiconductor device 100 having high breakdown voltage can be obtained.

Further, from the viewpoint of improving the degree of integration, the taper angle should preferably be not less than 65°, and from the viewpoint of preventing electric field concentration, the taper angle should preferably be not more than 75°

Further, in the present embodiment, before forming implantation inhibiting layer 4, through mask layer 2 is formed on silicon carbide layer 2. Therefore, when an opening is formed by etching implantation inhibiting layer 4, etching of silicon carbide layer 122 below through mask 2 can be prevented.

Further, according to the manufacturing method of the present embodiment, the step of forming an opening with the taper angle of 90° is performed and, thereafter, the taper angle is adjusted to be larger than 60° and not larger than 80°. Thus, the taper angle can be controlled with higher accuracy.

Further, according to the manufacturing method of the present embodiment, as the material for mask layer 1 (implantation inhibiting layer 4) and through mask layer 2, silicon dioxide and polysilicon are used. These materials are non-metal and, therefore, metallic contamination can be prevented.

The embodiments as have been described here are mere examples and should not be interpreted as restrictive. The scope of the present invention is determined by each of the claims with appropriate consideration of the written description of the embodiments and embraces modifications within the meaning of, and equivalent to, the languages in the claims.

### REFERENCE SIGNS LIST

1 mask layer, 2 through mask layer, 3 resist pattern, 4 implantation inhibiting layer, 5 JFET region, 10 substrate, 100 semiconductor device, 110 gate electrode, 111 source electrode, 112 drain electrode, 121 buffer layer, 122 silicon carbide layer (breakdown voltage holding layer), 123 well region, 124 n⁺ region, 125 p⁺ region, 126 oxide film, 127 upper source electrode.

## Claims

1. A. method for manufacturing a semiconductor device, comprising the steps of:
preparing a substrate (10) having a silicon carbide layer (122) of a first conductivity type;
forming a mask layer (1) on said silicon carbide layer; and
forming a well region (123) of a second conductivity type on said silicon carbide layer by ion implantation from above said mask layer; wherein
at said step of forming a mask layer, said mask layer is formed to have an opening with a taper angle as an angle formed between a bottom surface and an inclined surface of said mask layer being larger than 60° and not larger than 80°.

2. The method for manufacturing a semiconductor device according to claim 1, wherein
said step of forming a mask layer includes the steps of forming an implantation inhibiting layer (4) on said silicon carbide layer, and the step of forming said opening in said implantation inhibiting layer.

3. The method for manufacturing a semiconductor device according to claim 2, wherein
the step of forming said opening is conducted by etching said implantation inhibiting layer.

4. The method for manufacturing a semiconductor device according to claim 3, further comprising the step of
before forming said implantation inhibiting layer, forming a through mask (2) on said silicon carbide layer.

5. The method for manufacturing a semiconductor device according to claim 4, wherein
at the step of forming said opening, said implantation inhibiting layer is etched under the condition that selectivity between said through mask layer and said implantation inhibiting layer is not less than 2.

6. The method for manufacturing a semiconductor device according to claim 4 or 5, wherein
ratio of thickness of said implantation inhibiting layer divided by thickness of said through mask layer is not less than 10 and not more than 50.

7. The method for manufacturing a semiconductor device according to any of claims 2 to 6, wherein
the step of forming said opening includes the step of forming said opening to have said taper angle of 90°, and the step of adjusting said taper angle such that said taper angle of said opening comes to be larger than 60° and not larger than 80°.
